# EUROPÄISCHE PATENTSCHRIFT

(11) **EP 0 491 976 B1**
(45) Veröffentlichungstag und Bekanntmachung des Hinweises auf die Patenterteilung: **25.10.2000**
(21) Anmeldenummer: 90125289.0
(22) Anmeldetag: 21.12.1990
(51) Int. Cl.: H01L 21/225, H01L 21/205

(54) **Verfahren zur Herstellung einer mit Arsen dotierten glatten polykristallinen Siliziumschicht für höchstintegrierte Schaltungen**
Method for producing a smooth polycristalline silicon layer, doped with arsenide, for large scale integrated circuits
Méthode de fabrication d'une couche lisse de silicium polycristallin dopé à l'arsenic pour circuits intégrés LSI

(43) Veröffentlichungstag der Anmeldung: 01.07.1992
(73) Patentinhaber: SIEMENS AKTIENGESELLSCHAFT, 80333 München (DE)
(72) Erfinder: Wild, Barbara, Dipl.-Ing., W-7120 Bietigheim-Bissingen (DE)

(56) Entgegenhaltungen:
- US-A- 4 012 235
- JOURNAL OF APPLIED PHYSICS. vol. 65, no. 11, 01 Juni 1989, NEW YORK US Seiten 4435 - 4437; S.F. GONG et al.: "A metal-oxide-silicon field-effect transistor made by means of solid phase doping"
- APPLIED PHYSICS LETTERS. vol. 53, no. 10, 05 September 1988, NEW YORK US Seiten 902 - 904; S.F. GONG et al.: "Solid phase epitaxy and doping of Si through Sb-enhanced recrystallization of polycrystalline Si"
- APPLIED PHYSICS LETTERS. vol. 49, no. 7, 18 August 1986, NEW YORK US Seiten 382 - 384; A BROKMAN et al.: "Morphological effects during low pressure chemical vapor deposition and annealing of undoped polycrystalline silicon layers"
- APPLIED PHYSICS LETTERS. vol. 52, no. 17, 25 April 1988, NEW YORK US Seiten 1425 - 1427; G.K. CELLER et al.: "Release of As from SiO2 by a temperature gradient and formation of buried n+ conductive layers in Si-on-SiO2 structures"
- APPLIED PHYSICS LETTERS. vol. 55, no. 10, 04 September 1989, NEW YORK US Seiten 963 - 965; W.F.J. SLIJKERMAN et al.: "Structural characterization of an Sb delta-doping layer in silicon"
- JOURNAL OF APPLIED PHYSICS. vol. 65, no. 6, 15 März 1989, NEW YORK US Seiten 2485 - 2492; A.A VAN GORKUM et al.: "Growth and characterization of atomic layer doping structures in Si"
- PATENT ABSTRACTS OF JAPAN vol. 10, no. 158 (E-409)(2214) 06 Juni 1986, & JP-A-61 012031 (NIPPON DENSHIN DENWA KOSHA) 20 Januar 1986,
- PATENT ABSTRACTS OF JAPAN vol. 8, no. 268 (E-283)(1705) 07 Dezember 1984, & JP-A-59 138332 (SEIKO DENSHI KOGYO K.K.) 08 August 1984,
- 1989 Symposium on VLSI Technology, Kyoto 1989, Seiten 41,42, K.Sawada et al
- Widmann, Mader, Friedrich: Technologie hochintegrierter Schaltungen, Springer Verlag, 2 Auflage, Seite 16

## Beschreibung

Die Erfindung betrifft ein mehrstufiges verfahren zur Herstellung einer mit Arsen dotierten glatten polykristallinen Siliziumschicht für höchstintegrierte Schaltungen, durch thermische Zersetzung von die Elemente enthaltenden gasförmigen Verbindungen, bei dem direkt hintereinander eine dotierte Schicht und darüber eine undotierte Siliziumschicht in einem zweistufigen Prozeß abgeschieden werden.

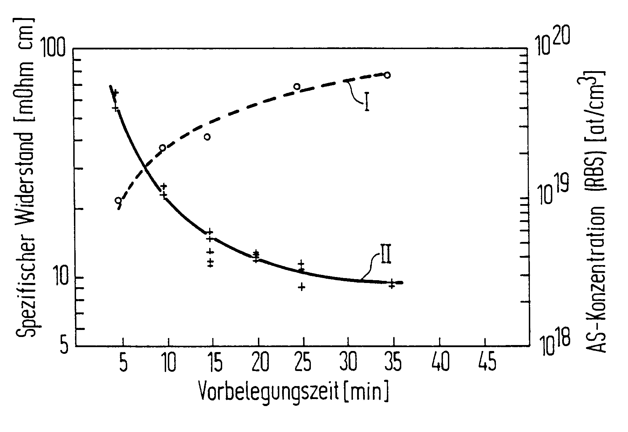

Die Erzeugung und Verwendung von Polysiliziumschichten bei der Herstellung von VLSI-Halbleiterschaltungen ist beispielsweise aus dem Buch "Technologie hochintegrierter Schaltungen", 1988, von D. Widmann, H. Mader und H. Friedrich (vgl. insbesondere Abschnitt 3.8 und Abbildung 5.3.2.) bekannt. In dem genannten Buch wird insbesondere auch die Verwendung einer (dotierten) Polysiliziumschicht als zweite, obere Kondensatorelektrode bei der Herstellung einer Grabenspeicherzelle beschrieben.

Bei der Entwicklung höchstintegrierter Bauelemente, beispielsweise dem 4 Mbit-DRAM, werden bei den Kondensator-Speicherzellen die planaren Zellen zunehmend wegen ihres zu großen Platzbedarfs durch Grabenzellen (Trenchzellen) mit hohem Aspektverhältnis (a = Verhältnis von Tiefe zu Durchmesser des Grabens) ersetzt. Für den 4M werden die Gräben mit einem Aspektverhältnis größer gleich 3 erzeugt. Der Einsatz dieser Trenchzellen führt vor allem dann zu einem Flächengewinn und damit zu höherer Integrationsdichte, wenn die Zellen mit möglichst geringem Abstand zueinander angeordnet werden könnten. Damit durch die dichte Packung der Trenchzellen die elektrischen Eigenschaften nicht verschlechtert werden, ist es beim 4M notwendig, daß die n⁺-Dotierung (Arsen) der ersten, unteren Kondensatorelektrode den Trench mit hoher Oberflächenkonzentration, aber geringer Eindringtiefe umgibt. Dieses steile Dotierungsprofil ist nötig, um in der späteren Trenchzelle einen elektrischen Überschlag (punch-through) während des Betriebs zu vermeiden.

Beim 4M ist es zur Herstellung einer Kondensator-Speicherzelle nach Ätzung des Grabens bisher üblich (vgl. Abb. 5.3.2. des obengenannten Buches), als erste, untere Kondensatorelektrode direkt das dotierte einkristalline Siliziumsubstrat zu verwenden. Die Dotierung kann dabei beispielsweise mit dem aus der EP-A-0 271 072 bekannten Verfahren vorgenommen werden, bei dem zunächst eine Hilfsschicht aus Arsenosilikatglas abgeschieden, anschließend die Arsendotierung durch Temperung in das Siliziumsubstrat eindiffundiert und die Hilfsschicht schließlich wieder entfernt wird. Auf die hoch n⁺-dotierte einkristalline Siliziumelektrode wird dann üblicherweise ein dünner SiO₂-Film als Dielektrikum aufgebracht. Die zweite, obere Kondensatorelektrode schließlich wird durch eine Polysiliziumelektrode gebildet, die gleichzeitig der Grabenauffüllung dient. Da undotierte Polysiliziumschichten sehr hochohmig sind, ist eine Dotierung notwendig, wobei prinzipiell entweder eine Dotierung während der Polysiliziumabscheidung ("in-situ"), beispielsweise durch Beimischung von Arsin (AsH₃) zum üblicherweise für die Abscheidung verwendeten Silan (SiH₄), oder das Aufbringen einer zusätzlichen Hilfsschicht notwendig und anschließende Eintreibung der Dotierung in Frage kommen. Im Hinblick auf eine noch höhere Integrationsdichte als beim 4M ist der Trench im weiteren Prozeßablauf jedoch teilweise bereits soweit aufgefüllt, daß dies nicht mehr möglich ist.

Für die Realisierung des 16 Mbit-DRAM wurde ein Trench-zu-Trench-Abstand von ca. 0,8 µm vorgegeben. Damit bei diesem sehr geringen Abstand keine Überlappung der Raumladungs-Zonen auftritt, müssen die Diffusionsgebiete der Trenches entweder durch eine isolierende Schicht voneinander getrennt, oder die Diffusionsgebiete sehr flach gehalten werden. In beiden Fällen kann das einkristalline Siliziumsubstrat nicht mehr direkt zur Bildung der unteren Kondensatorelektrode dienen, sondern es muß dafür eine eigene elektrisch leitende Schicht abgeschieden weden. Erst dann können, wie beim 4M, das ONO-Dielektrikum (Dreifachschicht aus Siliziumoxid (O) und Siliziumnitrid (N)) und die obere Polysiliziumelektrode hergestellt werden. Die neue untere Elektrode muß dabei einerseits eine möglichst glatte Oberfläche aufweisen, damit das empfindliche Dielektrikum keinen Qualitätsverlust erleidet und andererseits darf die gesamte Dotierung nicht über 10²⁰ Atome/cm³ liegen, damit die nachfolgenden Prozeßschritte nicht z. B. durch zu hohe Aufwachsraten des ONO-Bottom-Oxids beeinträchtigt werden.

Die letztgenannte Forderung könnte zwar durch Dotierung durch Diffusion aus einer Arsen-Glas-Schicht erfüllt werden, was jedoch mehrere zusätzliche Prozeßschritte, d. h. auch eine längere Prozeßzeit erforderlich machen würde. Als Dotierelement kommt jeweils nur Arsen in Frage, da Phosphor einen relativ hohen Diffusionskoeffizienten hat und zu ausgedehnte Diffusionsgebiete in den Trench-Seitenwänden erzeugen würde. Was die geforderte Oberflächenqualität der neuen Kondensatorelektrode betrifft, so ist bekannt, daß polykristallines Silizium aufgrund seiner Kornstruktur eine rauhe Oberfläche aufweist, während amorphes Silizium, das bei einer Temperatur unterhalb 590°C abgeschieden werden kann, eine vollkommen glatte Oberfläche aufweist. Es ist ferner bekannt, daß bei Temperaturen oberhalb von 1000°C auf Siliziumscheiben abgeschiedene Siliziumschichten die Kristallorientierung des einkristallinen Siliziumsubstrats annehmen (Epitaxie).

Um zusätzliche Verfahrensschritte zu vermeiden, bietet sich - wie bereits erwähnt - generell die in-situ-Dotierung von Siliziumschichten an, bei der die zur Schichtabscheidung notwendige Menge an Silan gleichzeitig mit dem Dotiergas in den Reaktor eingelassen wird. Dabei ergeben sich jedoch unerwünschte Wechselwirkungen, die zu einer Veränderung der Abscheideraten und zu über die Reaktorlänge ungleichmäßigen Einbau des Dotierstoffes führen. Dem Artikel von F.C. Eversteyn et al., J. Electrochem. Soc., Vol. 120, No. 1, 1973, ist ferner zu entnehmen, daß es besonders bei der Verwendung des Dotiergases Arsin zu einer bevorzugten Adsorption des Arsins vor Silan an der heißen Waferoberfläche kommt. Bei dieser Prozeßführung nimmt mithin die Abscheiderate stark ab, gleichzeitig wird aber eine relativ große Menge ( >> 10²⁰ Atome/cm³) an Arsen eingebaut. Dieses Verfahren ist deshalb für die Herstellung der oben geforderten neuen Kondensatorelektroden ungeeignet.

Im Artikel von K. Sawada, Sympos. on VLSI Technology Digest of Techn. Papers, Kyoto 1989, S. 41 - 42, wurde ein doppelstufiges Verfahren vorgestellt, bei dem eine mit Phosphor dotierte Polysiliziumschicht mit einer unmittelbar anschließend abgeschiedenen undotierten Polysiliziumschicht kombiniert wird, so daß die verringerte Abscheiderate nur teilweise zum Tragen kommt. Durch Temperung ergibt sich eine nahezu homogen dotierte Gesamtschicht. Jedoch entstehen auch bei diesem Verfahren bei der Verwendung von Arsin zu hoch dotierte Siliziumschichten, wie die entsprechenden Versuche zeigten. Weitere Versuche zeigten, daß auch bei der Kombination einer dotierten mit einer sofort anschließend abgeschiedenen undotierten amorphen Siliziumschicht die mittlere Gesamtkonzentration des Arsens immer noch bei über 10²⁰ Atome/cm³ liegt, also zu hoch für die vorgesehene Anwendung. Es ist zwar prinzipiell möglich, die Arsen-Konzentration durch eine Vergrößerung der Dicke der undotierten Si-Schicht zu verringern, jedoch würde dies nicht zu den in der Praxis erwünschten Schichtdicken von etwa 100 nm und weniger führen. Außerdem ist nach der Temperung die nach dem Verfahren von K. Sawada hergestellte Schichtoberfläche deutlich rauher als bei normaler amorpher Siliziumabscheidung üblich.

Aufgabe der Erfindung ist es, ein Verfahren der eingangs genannten Art anzugeben, das zu einer konformen und homogen dotierten Polysiliziumschicht führt, die eine glatte Oberfläche aufweist.

Die erfindungsgemäße Aufgabe wird durch ein Verfahren gemäß Anspruch 1 gelöst. Weitere Ausführungsbeispiele werden in den Ansprüchen 2 bis 8 dargestellt.

Im Artikel von S.F. GONG et al., Journal of Applied Physics, Vol 65, Nº 1,S 4435 bis 4437 wurde ein mehrstufiges Verfahren dargestellt, bei dem eine dotierte Polysiliziumschicht abgeschieden wird.

Die Abscheidung von Arsen-dotiertem amorphen Silizium durch Arsen-Vorbelegung und zeitlich getrennte aber sofort, d. h. ohne daß die Wafer den Reaktor verlassen, anschließende Siliziumabscheidung ist ein geeignetes Verfahren, um niedrig dotierte Siliziumschichten mit guter Kantenbedeckung und guter Oberflächenqualität zu erzeugen. Im Vorbelegungsschritt wird zunächst nur eine beispielsweise 1 % Arsin-in-Silan-Mischung bei geringem Druck (13 bis 20 Pa) für bestimmte Zeit durch den Reaktor geleitet. Dabei entsteht eine sehr dünne (ca. eine Monolage), hoch Arsen-dotierte Schicht. Diesem Schritt folgt die Abscheidung von undotiertem amorphen Silizium. Bei der anschließenden Temperung kristallisiert das amorphe Silizium zu Polysilizium aus und das Arsen diffundiert in begrenzter Menge in die undotierte Siliziumschicht. Obwohl die amorphe Siliziumschicht bei der Temperaturbehandlung kristallisiert, bleibt dabei ihre glatte Oberfläche weitgehend erhalten.

Das erfindungsgemäße Verfahren weist darüberhinaus gegenüber dem Stand der Technik eine Reihe von Vorteilen auf:
- Über die Dauer der Vorbelegung und die Dicke der undotierten Schicht läßt sich der Schichtwiderstand und die Gesamtdotierung über einen Bereich von 5 x 10¹⁸ bis 10²⁰ Atome/cm³ einstellen.
- Die Homogenität der Dotierung ist deutlich besser als bei gleichzeitiger Abscheidung und weniger von der Boot- und Reaktorgeometrie abhängig, da sich das Arsin bei dem niedrigen Vorbelegungsdruck sehr gut verteilen kann. Auch die Kantenbedeckung im Trench ist besser als sonst bei in-situ-dotierten Prozessen.
- Die Abscheiderate ist, abgesehen von einer kurzen Anlaufphase nach der As-Belegung, fast so hoch wie bei normaler amorpher Si-Abscheidung, d. h. die Prozeßzeiten liegen im üblichen Rahmen.
- Das Bottom-Oxid des Dreifach-Dielektrikums wächst zunächst auf einer niedrig bzw. undotierten Unterlage auf, da das Arsen nur langsam aus der Vorbelegungsschicht zur Oberfläche diffundiert. Damit ist die Oxidationsrate unabhängig von der Ziel-Dotierung.

Ein weiterer wichtiger Vorteil ergibt sich daraus, daß durch die undotierte Abscheidung alles Arsin, das von der Reaktoroberfläche abgegeben wird, im Silizium gebunden wird. Damit kann beim Ausfahren des Bootes beim Entladen und von den beschichteten Quarzteilen kein Arsin in die Umluft gelangen. Die verringerte Kontaminationsgefahr trägt wesentlich zur Sicherheit des Verfahrens bei.

Der erfindungsgemäße, mindestens zweistufige (d. h. mindestens ein Zyklus Vorbelegung/Abscheidung) Prozeß ermöglicht es, auf 50 Sechs-Zoll-Scheiben Arsen-dotiertes Silizium mit sehr guter Kantenbedeckung und so glatter Oberfläche zu erzeugen, daß es für den Einsatz als Polyelektrode unter dem ONO-Dielektrikum verwendet werden kann. Im Vergleich zur Dotierung über Ausdiffusion aus Arsen-Glas können mehrere Prozeßschritte eingespart werden. Auch die Auffüllung der Trenches in einem Schritt ist mit diesem Prozeß möglich. Da der Trench besonders im unteren Teil sehr schmal ist, füllt die obere Polyelektrode dort den Trench ganz aus, so daß dieser Bereich durch Phosphor-Diffusion nicht mehr dotiert werden kann. Als Ersatz dient eine Arsen-dotierte Si-Schicht, die zur Verbesserung der Leitfähigkeit nur im oberen Teil zusätzlich mit Phosphor dotiert wird.

Im folgenden wird die Erfindung anhand eines Ausführungsbeispieles und der FIG, deren Diagramm den Einfluß der Vorbelegungszeit auf den Schichtwiderstand und die Arsen-Konzentration zeigt, näher erläutert.

Die Ausführung des Verfahrens erfolgt in einem horizontalen LPCVD-Reaktor. Um eine ausreichende Dotiergleichmäßigkeit zu erreichen, wird ein an sich bekanntes gedecktes Boot ("cage-boat") mit angepaßter Lochverteilung verwendet. Ohne dieses Boot kommt es zum sog. "Bull-eye"-Effekt, d. h. zu einem starken radialen Dotierstoff-Gradienten über die Scheibe. Die maximale Kapazität des Bootes beträgt 60 Wafer bei einem Abstand von 8.9mm. Die Verteilung des Arsin/Silan-Gemisches wird über einen sog. ebenfalls bekannten Doppelinjektor gesteuert. Dieser besteht aus einem einseitig geschlossenen Glasrohr von Prozeßrohr-Länge und etwa 12mm Durchmesser, das in das Prozeßrohr eingeschoben wird und mit der Gaszuleitung verbunden wird. Im Bereich, der unter dem Boot zu liegen kommt, befindet sich eine Reihe von 1 mm großen Löchern, durch die das Gas ausströmen kann. Im Innern des Injektors befindet sich eine Kapillare von gleicher Länge, durch die über eine zweite Prozeßgasleitung Gas in den vorderen Injektorteil geführt werden kann. Durch günstige Aufteilung der Gasmenge auf die beiden Injektor-Zuführungen kann also die Gasverteilung über die Bootslänge optimiert werden. Prozeßgase sind Silan, Argon und 1% Arsin in Silan.

Es wurde festgestellt, daß bei der Vorbelegung bereits bei geringfügig erhöhtem Druck (z. B. 50 Pa) eine relativ dicke Schicht (20-30nm) aufwächst. Diese besteht wahrscheinlich aus einer hoch Arsen-haltigen Silizium-Schicht und ist damit für den Zielprozeß ungeeignet. Je niedriger der Druck wird, desto gleichmäßiger wird, besonders bei Einleitung über den inneren Injektor, die Vorbelegung. Bei 30 sccm und einem Druck von 13 bis 16 Pa ist die Vorbelegungsschicht zwar fast unmessbar dünn, aber über die Rohrlänge und die Scheibe sehr gleichmäßig.

Ein typischer Verfahrensablauf folgt folgendem Schema:

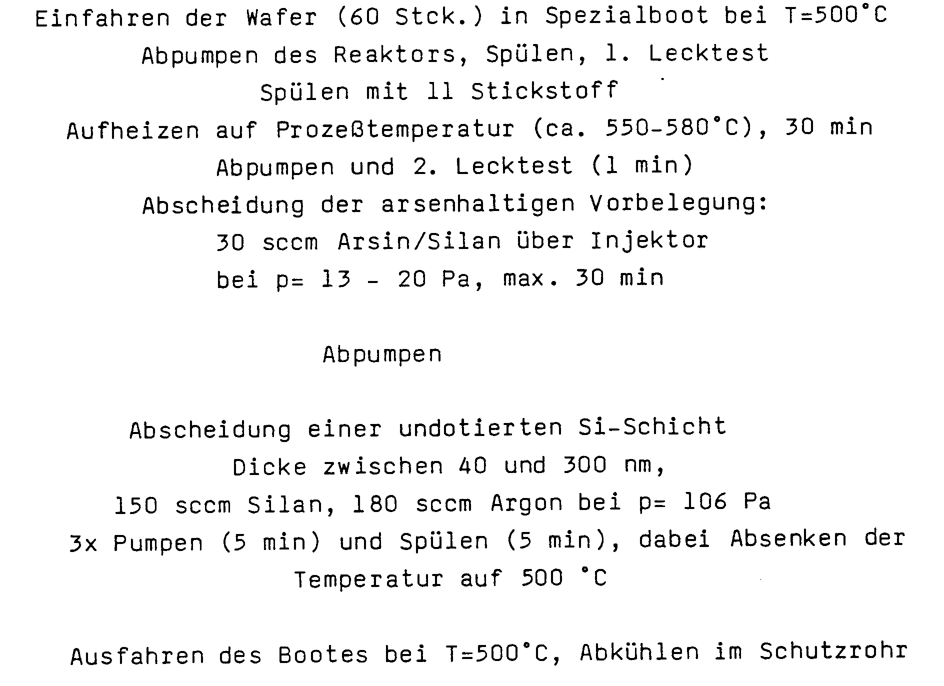

Die Prozeßbedingungen und die Zeitdauer der Vorbelegung bestimmen die gesamte Arsenmenge, die später in der Siliziumschicht zu finden ist. Um eine gleichmäßige Arsenbelegung sowohl über das Boot als auch über die Scheibe zu erreichen, hat sich, wie bereits erwähnt, ein geringer Vorbelegungs-Druck von 13 - 20, vorzugsweise bis 16 Pa als günstig erwiesen. Bei der Vorbelegung wurde aus praktischen Gründen die gleiche Temperatur wie bei der späteren undotierten Abscheidung gewählt. Unter Berücksichtigung dieser Randbedingungen bietet es sich an, die Menge des abgeschiedenen Arsens in erster Linie über die Belegungsdauer zu steuern. Dies ermöglicht eine einfache Anpassung des Prozesses an verschiedene Spezifikationen, ähnlich der Steuerung der Schichtdicke über die Zeit.

Die Figur zeigt den Einfluß der Vorbelegungszeit auf die As-Konzentration (Kurve I) und den Schichtwiderstand (Kurve II) in einer 150 nm dicken Schicht nach Temperung (Belegungsbedingung T = 550°C, p = 13 Pa, Temperung 900°C für eine Stunde). Es wurde gefunden, daß nur ein Teil (ca. 40 - 50 %) des Arsens in die kristallisierende Si-Schicht diffundiert, der Rest jedoch an der Grenzfläche verbleibt. Dies reicht aus, um As-Konzentrationen von 5 x 10¹⁸ bis 10²⁰ Atome /cm³ in der Schicht zu erzeugen. Gerade dieser Dotierungsbereich ist für den vorliegenden Anwendungsfall optimal geeignet. Zu erkennen ist auch, daß sich nach ca. 30 min ein Sättigungseffekt hinsichtlich (des Dickenzuwachses) der Vorbelegung einstellt.

Die Abscheidebedingungen für die undotierte amorphe Schicht wurden so gewählt, daß eine möglichst gute Amorphität erreicht wird. Optimale Ergebnisse wurden bei einem Druck von 87 - 106 Pa bei einem Silan-Partialdruck von ca. 38 - 45 Pa (Verdünnung mit Argon) erzielt. Besonders gute Ergebnisse hinsichtlich der Oberflächen-Rauhigkeit wurden bei einer Abscheidetemperatur bei der Vorbelegung von 555°C und einem Druck von nicht wesentlich mehr als 87 Pa bei der undotierten Abscheidung erreicht. Da die Herstellung einer unteren Kondensatorelektrode mit Blick auf die Oberflächenqualität kritischer ist, wurde dabei der niedrigere Abscheidedruck von 87 Pa gewählt, während die obere, dickere und unkritischere Polyelektrode bei 106 Pa abgeschieden wird.

Es zeigte sich auch, daß das erfindungsgemäße Verfahren insofern "robust" ist, als zwischen dem Vorbelegungsschritt und der Si-Abscheidung ein Spülschritt von 30 min eingebaut werden kann. Die auf diese Weise hergestellten Schichten zeigten dennoch die gleichen Schichtwiderstände wie bei nicht gespültem Prozeß. Eine verringerte Arsen-Konzentration durch Abdampfen tritt nicht auf.

Das erfindungsgemäße Verfahren läßt eine Reihe von Variationsmöglichkeiten zu. So können durch Wiederholung von Vorbelegung und undotierter Abscheidung auch dickere Schichten, z. B. 600 nm (zweimaliges Vorbelegen und Abscheiden) oder 900 nm (dreimaliges Vorbelegen und Abscheiden) hergestellt werden. Um eine höhere Dotierung zu erreichen, kann die Dicke der undotierten Si-Schicht verringert werden. So wurde z. B. eine 300 nm-Schicht durch jeweils Vorbelegen und 150 nm undotierte Abscheidung hergestellt, die einen Schichtwiderstand von 7 mOhm x cm hatte (sonst 20 MOhm x cm).

## Patentansprüche

1. Mehrstufiges Verfahren zur Herstellung einer dotierten glatten polykristallinen Siliziumschicht für höchstintegrierte Schaltungen bei dem direkt hintereinander eine dotierte Schicht und darüber eine undotierte amorphe, Siliziumschicht in einem zweistufigen Prozeß abgeschieden werden, und daß nachfolgend eine gleichmäßige Dotierung der Siliziumschicht durch die als Diffusionsquelle dienende dotierte Schicht durch eine Temperaturbehandlung erfolgt, bei der gleichzeitig das amorphe Silizium zu einer polykristallinen Siliziumschicht ausgebildet wird
**dadurch gekennzeichnet,** daß die Dotierung mit Arsen durchgeführt wird, und
a) zunächst mit einer Arsin-in-Silan-Gasmischung bei einem Druck von 13 bis 20 Pa eine oberflächendeckende, etwa eine Monolage dicke arsen-dotiert Schicht als Vorbelegung abgeschieden wird und
b) auf diese anschließend die undotierte amorphe Siliziumschicht bei einer Temperatur unterhalb von 580°C durch thermische Zersetzung von die Elemente enthaltenden gasförmigen Verbindungen abgeschieden wird.

2. Verfahren nach Anspruch 1,
**dadurch gekennzeichnet,** daß die Verfahrensschritte a) und b) vor Ausführung der weiteren Verfahreneschritte mindestens einmal wiederholt werden.

3. Verfahren nach Anspruch 1 oder 2,
**dadurch gekennzeichnet,** daß der Druck im Verfahrensschritt a) auf einen Bereich von 13 - 16 Pa eingestellt wird.

4. Verfahren nach einem der Ansprüche 1 bis 3,
**dadurch gekennzeichnet,** daß in den Verfahrensschritten a) und b) die Schichten bei einer Temperatur abgeschieden werden, die jeweils zwischen etwa 550 und 580°C liegt.

5. Verfahren nach einem der Ansprüche 1 bis 4,
**dadurch gekennzeichnet,** daß die Verfahrensschritte a) und b) bei der gleichen Temperatur ausgeführt werden.

6. Verfahren nach einem der Ansprüche 1 bis 5,
**dadurch gekennzeichnet,** daß die Menge des abgeschiedenen Arsens durch die Zeitdauer des Vorbelegungsschrittes a) eingestellt wird.

7. Verfahren nach einem der Ansprüche 1 bis 6,
**dadurch gekennzeichnet,** daß durch Einstellung der Dicke der im Verfahrensschritt b) abgeschiedenen undotierten Siliziumschicht eine Polysilizium-Schicht mit einer Arsen-Konzentration von etwa 10¹⁹ bis 10²⁰ Atome/cm³ erzeugt wird.

8. Verfahren nach einem der Ansprüche 1 bis 7,
**dadurch gekennzeichnet,** daß im Verfahrensschritt a) eine 1 % Arsin-in-Silan-Gasmischung und im Verfahrensschritt b) vorzugsweise eine Silan/Argon-Gasmischung verwendet wird.

## Claims

1. Multi-stage method for producing a doped, smooth polycrystalline silicon layer for very large scale integrated circuits, in which a doped layer and, above the latter, an undoped, amorphous silicon layer are deposited directly one after the other in a two-stage process, and the silicon layer is subsequently doped uniformly by the doped layer, serving as a diffusion source, by means of a thermal treatment, in which the amorphous silicon is simultaneously formed into a polycrystalline silicon layer,
characterized in that the doping is carried out using arsenic, and
a) first of all, using an arsine-in-silane gas mixture at a pressure of 13 to 20 Pa, a surface-covering, arsenic-doped layer having a thickness of approximately one monolayer is deposited as predeposition, and
b) the undoped amorphous silicon layer is subsequently deposited thereon at a temperature of below 580°C by means of thermal decomposition of gaseous compounds containing the elements.

2. Method according to Claim 1,
characterized in that
the method steps a) and b) are repeated at least once before the further method steps are performed.

3. Method according to Claim 1 or 2,
characterized in that
the pressure in the method step a) is set to a range of 13 - 16 Pa.

4. Method according to one of Claims 1 to 3,
characterized in that
in the method steps a) and b), the layers are deposited at a temperature which in each case lies between approximately 550 and 580°C.

5. Method according to one of Claims 1 to 4,
characterized in that
the method steps a) and b) are performed at the same temperature.

6. Method according to one of Claims 1 to 5,
characterized in that
the quantity of arsenic deposited is set by the time duration of the predeposition step a).

7. Method according to one of Claims 1 to 6,
characterized in that
by setting the thickness of the undoped silicon layer deposited in the method step b), a polysilicon layer is produced with an arsenic concentration of approximately 10¹⁹ to 10²⁰ atoms/cm³.

8. Method according to one of Claims 1 to 7,
characterized in that
a 1% arsine-in-silane gas mixture is used in the method step a) and a silane/argon gas mixture is preferably used in the method step b).

## Revendications

1. Procédé à plusieurs étages pour fabriquer une couche lisse de silicium polycristallin dopé pour des circuits à très haut degré d'intégration au cours duquel sont déposées, directement l'une derrière l'autre, en un processus à deux étages, une couche dopée et, au dessus d'elle, une couche de silicium amorphe non dopée et au cours duquel on procède ensuite, par traitement thermique, à un dopage régulier de la couche de silicium à travers la couche dopée, qui sert de source de diffusion, pendant que le silicium amorphe devient en même temps une couche de silicium polycristallin
**caractérisé par le fait**
que le dopage est réalisé avec de l'arsenic et
a) que, d'abord, une couche, épaisse d'environ une couche monomoléculaire, dopée à l'arsenic et qui recouvre la surface, est déposée comme dépôt préalable, grâce à un mélange gazeux d'arsine dans du silane sous une pression de 13 à 20 Pa, et
b) qu'ensuite, sur celle-ci, la couche de silicium amorphe non dopée est déposée, à une température inférieure à 580° C, par décomposition thermique de combinaisons gazeuses qui contiennent les éléments.

2. Procédé selon la revendication 1
**caractérisé par le fait**
que les étapes a) et b) du procédé sont répétées au moins une fois avant d'exécuter les étapes suivantes du procédé.

3. Procédé selon la revendication 1 ou 2
**caractérisé par le fait**
que, au cours de l'étape a) du procédé, la pression est réglée à l'intérieur d'une plage de 13 - 16 Pa.

4. Procédé selon l'une des revendications 1 à 3
**caractérisé par le fait**
que, au cours des étapes a) et b) du procédé, les couches sont déposées à une température qui se trouve, suivant les cas, entre environ 550 et 580° C.

5. Procédé selon l'une des revendications 1 à 4
**caractérisé par le fait**
que les étapes a) et b) du procédé sont exécutées à la même température.

6. Procédé selon l'une des revendications 1 à 5
**caractérisé par le fait**
que la quantité d'arsenic déposé est réglée par l'intermédiaire de la durée de l'étape du dépôt préalable a).

7. Procédé selon l'une des revendications 1 à 6
**caractérisé par le fait**
que, grâce au réglage de l'épaisseur de la couche de silicium non dopée déposée au cours de l'étape b) du procédé, une couche de polysilicium est produite dont la concentration en arsenic se situe entre environ 10¹⁹ et 10²⁰ atomes/cm3.

8. Procédé selon l'une des revendications 1 à 7
**caractérisé par le fait**
que, pour l'étape a) du procédé, on utilise un mélange gazeux de 1 % d'amine dans du silane et, pour l'étape b) du procédé, de préférence, un mélange gazeux de silane et argon.
